Europäisches Patentamt

European Patent Office

Office européen des brevets

(11) Veröffentlichungsnummer: **0 422 414 A1**

# EUROPÄISCHE PATENTANMELDUNG

(21) Anmeldenummer: 90117843.4

(22) Anmeldetag: 17.09.90

(51) Int. Cl.⁵: **H01J 37/04, H01J 37/147**

(30) Priorität: 07.10.89 DE 3933569

(43) Veröffentlichungstag der Anmeldung:
17.04.91 Patentblatt 91/16

(84) Benannte Vertragsstaaten:
AT BE CH DE ES FR GB IT LI NL SE

(71) Anmelder: MESSER GRIESHEIM GMBH
Hanauer Landstrasse 330
W-6000 Frankfurt/Main 1(DE)

(72) Erfinder: Scheffels, Wilhelm Dr.
Lessingstrasse 26
W-8036 Hersching(DE)

(54) Verwendung eines im Zwischenfokusbereich zwischen zwei Linsen angeordneten Ablenksystemes.

(57) Um bei durch Ablenkung des Elektronenstrahles erzeugten Elektronenstrahlimpulsen ein seitliches Bewegen des Hauptfokus zur Strahlachse (12) zu vermeiden, wird erfindungsgemäß ein auf Höhe des Zwischenfokus (4) zwischen zwei Linsen (3, 5) angeordnetes Ablenksystem (9) und der zweiten Linse (5) angeordnete Strahlblende (10) zum Erzeugen von Elektronenstrahlimpulsen durch Ablenken des Elektronenstrahles (2) auf die Strahlblende (10) oder auf eine Werkstückanordnung (7) verwendet.

Fig.2a    Fig.2b    Fig.2c    Fig.2d

EP 0 422 414 A1

## VERWENDUNG EINES IM ZWISCHENFOKUSBEREICH ZWISCHEN ZWEI LINSEN ANGEORDNETEN AB-LENKSYSTEMES

Die Erfindung betrifft die Verwendung eines im Zwischenfokusbereich zwischen zwei Linsen angeordneten Ablenksystemes und einer zwischen dem Ablenksystem und der zweiten Linse angeordneten Strahlblende.

Beim Bearbeiten mittels Elektronenstrahlen wird das Bearbeitungsergebnis wesentlich durch die absorbierte bzw. durch Wärmeleitung einem bestimmten Volumenelement zugeführte Energie bestimmt. Aufgrund der für die verschiedenen Effekte und Werkstoffe unterschiedlichen volumenspezifischen Energieaufwendungen ergibt sich an das Elektronenstrahlgerät die Forderung nach der Bearbeitungsaufgabe angepassten Werten der Strahlparameter. Das betrifft unter anderem die zeitliche Steuerung der Strahleinwirkdauer am vorgegebenen Bearbeitungsort.

Aus der DE 24 51 366 C3 ist ein Elektronenstrahlgerät bekannt, bei dem ein Elektronenstrahl, der durch eine magnetische Linse auf das Werkstück fokusiert wird, durch ein magnetisches Ablenksystem wechselweise auf eine unabgelenkte Arbeitsposition, in der er auf das Werkstück auftrifft und eine abgelenkte Ruheposition, in der er auf einen Auffänger auftrifft, ablenkbar ist. In den Fig. 1a bis d sind hierbei die einzelnen Stadien während der Ablenkung dargestellt. Fig. 1a zeigt die Arbeitsposition, in der der Elektronenstrahl 2 auf die Werkstückanordnung 7 auftrifft. Die Linse 5 konzentriert das Strahlenbündel in einen möglichst engen Fleck auf der Werkstückanordnung. Dazu sammelt die Linse 5 alle von dem Strahlenausgangspunkt in der Elektronenstrahlquelle (dem "Crossover") ausgehenden Elektronenstrahlen 2 wieder in einen Überkreuzungspunkt, den "Arbeitsfokus" 6. Bei jeder rotationssymmetrischen Linse wird der durch den Linsenmittelpunkt 13 verlaufende Elektronenstrahl nicht in der Linse 5 gekrümmt, sondern verläuft als gerade Linie durch die Linse hindurch. Dies ist die Strahlachse 12 und auf ihr liegt sowohl der Crossover 14 als auch der Arbeitsfokus 6.

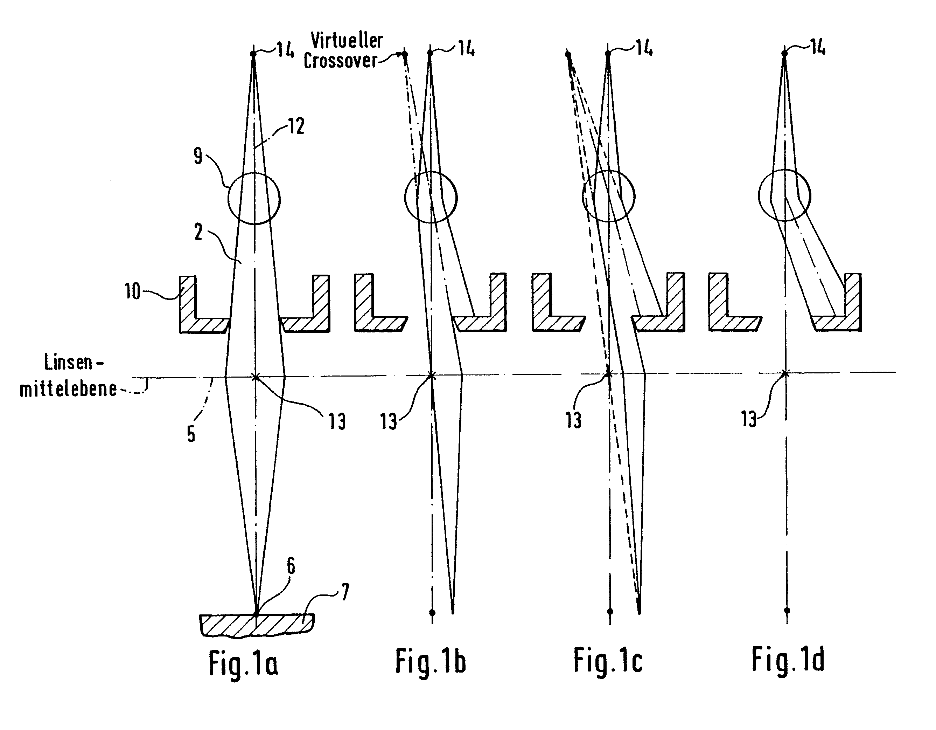

Der Linsenmittelpunkt 13 ist dadurch definiert, daß dort die Linsenachse die Linsenmittelebene durchstößt. Im Regelfall ist die Linsenachse (die Rotationsachse der oben als rotationssymmetrisch angenommenen Linse bzw. der die Linse bildenden Magnetfeld-Verteilung) nahezu identisch mit der mechanischen Symmetrieachse der die Linse erzeugenden Teile. Damit die Abbildung des Crossovers in den Arbeitsfokus optimal, also mit möglichst geringen Abbildungsfehlern erfolgt, ist man darum bemüht, daß die Strahlachse auf der Linsenachse zu liegen kommt. Fig. 1d zeigt die Ruheposition, in der der Elektronenstrahl 2 vollständig auf einen Auffänger 10 auftrifft. Fig. 1b und c zeigen Zwischenstadien während der Ablenkung des Elektronenstrahles von seiner Arbeits- in die Ruheposition. Dabei ist der Elektronenstrahl 2 zwischen Crossover 14 und Linse 5 abgelenkt (geknickt) wodurch sich die Abbildung des Crossovers 14 in den Arbeitsfokus 6 allein entsprechend der Richtung, mit der die (abgelenkten) Elektronenstrahlen auf die Linsenmittelebene zulaufen, ergibt. Der durch den Linsenmittelpunkt 13 laufende Elektronenstrahl wird zur Strahlachse (gestrichelt dargestellt), auf dieser Geraden liegt dann der Arbeitsfokus 6. Aber auf der umgekehrten Verlängerung dieser Geraden über das Ablenksystem hinaus liegt dann der "virtuelle" Crossover. Der Fokuspunkt wandert dabei während der Ablenkung seitlich zur Strahlachse 12 und damit zur vorgesehenen Auftreffstelle auf dem Werkstück aus. Hierdurch entstehen von der Bearbeitungsaufgabe abweichende Veränderungen in der Geometrie bzw. im Aufschmelzverhalten des Werkstoffes. Diese Veränderungen nehmen bei geringen Ablenkgeschwindigkeiten zu.

Die DE-OS 26 27 632 enthält einen Elektronenstrahlerzeuger, der einen nahe der Elektroden des Elektronenstrahlerzeugers gelegenen Bereich geringsten Strahlquerschnittes aufweist. Dieser erste Bereich geringsten Strahlquerschnittes wird durch eine erste Linse in einen zweiten Bereich geringsten Strahlquerschnittes (Zwischenfokus) abgebildet und das von diesem Zwischenfokus dann wieder divergierende Teilchenstrahlbündel wird durch eine zweite oder Hauptlinse in einen Hauptfokus oder Arbeitsfokus in oder bei einer Bearbeitungszone einer Werkstückanordnung fokusiert. Dabei ist zwischen dem Zwischenfokus und der zweiten Linse eine Strahlblende angeordnet, die dort den Bündelquerschnitt begrenzt und die Abbildungsfehler verringern soll, so daß sich Sein schärferer Fokus ergibt. Bei einem solchen Abbildungssystem kann am Ort des Zwischenfokus ein Ablenksystem vorgesehen werden.

Ferner ist aus der DE 28 15 478 C2 eine Doppel-Linsen-Anordnung bekannt, bei der zur Verbesserung der Abbildungseigenschaften eine Strahlblende zwischen der ersten und zweiten Linse angeordnet ist.

Der vorliegenden Erfindung liegt die Aufgabe zugrunde, bei durch Ablenkung des Elektronenstrahles erzeugten Elektronenstrahlimpulsen ein seitliches Bewegen des Hauptfokus zur Strahlachse zu vermeiden.

Diese Aufgabe wird erfindungsgemäß durch die Verwendung eines im Zwischenfokus zwischen zwei Linsen angeordneten Ablenksystemes und einer zwischen dem Ablenksystem und der zweiten Linse angeordneten Strahlblende zum Erzeugen von Elektronenstrahlimpulsen durch Ablenken des Elektronenstrahles auf die Strahlblende oder auf eine Werkstückanordnung gelöst.

Die Unteransprüche betreffen vorteilhafte Weiterbildungen und vorteilhafte Ausgestaltungen eines Elektronenstrahlimpulsgerätes. Durch die Erfindung wird die Bewegung des fokusierten Elektronenstrahles seitlich zur Strahlachse vermieden. Beschädigungen des Werkstückes, wie sie insbesondere bei langsamen Ablenkgeschwindigkeiten entstehen können, treten nicht auf.

Ein Ausführungsbeispiel der Erfindung ist in der Zeichnung dargestellt und wird im folgenden näher beschrieben.

Es zeigen

Fig. 1 den Funktionsablauf zum Erzeugen von Elektronenstrahlimpulsen mittels einer Strahlblende nach dem Stand der Technik.

Fig. 2 den Funktionsablauf zum Erzeugen von Elektronenstrahlimpulsen nach der Erfindung.

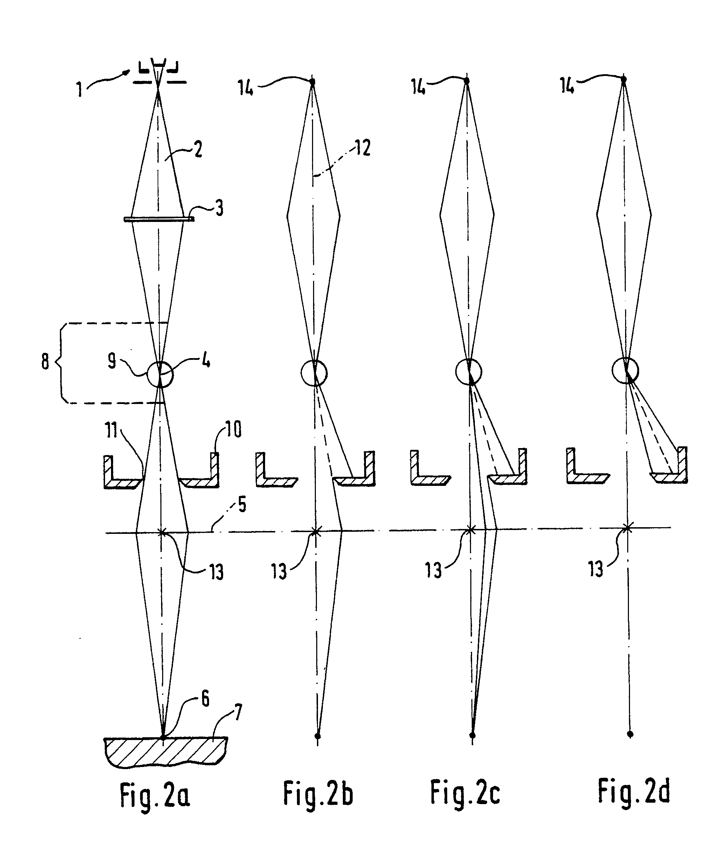

In der Fig. 2 wird der von einer Elektronenstrahlquelle 1 erzeugte Elektronenstrahl 2 mit einer ersten teilchenoptischen Linse 3 in einem Zwischenfokus 4, in dem der effektive Strahlquerschnitt ein Minimum hat, fokusiert. Das von diesem Zwischenfokus 4 wieder divergierende Teilchenstrahlbündel wird durch eine zweite oder Hauptlinse 5 in einen Hauptfokus 6 (Arbeitsfokus) in oder bei einer Bearbeitungszone einer Werkstückanordnung 7 fokusiert. Der Zwischenfokus 4 zwischen den Linsen 3 und 5 liegt vorzugsweise in der Mittelebene eines Ablenksystemes 9. Zwischen dem Ablenksystem 9 und der Hauptlinse 5 ist eine Strahlblende 10 angeordnet.

Zum Erzeugen von Elektronenstrahlimpulsen wird der Elektronenstrahl 2 mittels des Ablenksystemes 9 durch die Strahlblendenbohrung 11 in oder bei einer Bearbeitungszone der Werkstückanordnung 7 fokusiert. Ist die innerhalb einer Strahleinwirkzeit in der Bearbeitungszone wirkende Energie übertragen, wird der Elektronenstrahl 2 mittels des Ablenksystemes 9 auf die Strahlblende 10 abgelenkt (Fig. 2d)

Wie aus den Fig. 2b und c, in denen der Strahlverlauf am Ablenkbeginn und kurz danach dargestellt ist, zu ersehen ist, verbleibt der Elektronenstrahl 2 beim Übergang von der Arbeitsposition (Fig. 1a) in die Ruheposition (Fig. 2d) ohne seitliche Abweichung im Hauptfokus 6 zentriert, wodurch Veränderungen des Werkstückes außerhalb der Bearbeitungszone vermieden werden. Die Vermeidung der seitlichen Abweichung beim Erzeugen von Elektronenstrahlimpulsen ergibt sich dadurch, daß der Überkreuzungspunkt ("Fokus") 4 vor der Hauptlinse 5 ein Zwischenfokusbereich 8 ist, der von der Vor-Linse 3 gebildet wird und nicht der Crossover der Elektronenstrahlquelle 1 wie in Fig. 1a. Dabei liegen aber in Fig. 2a der Zwischenfokus 4, der Linsenmittelpunkt der Linse 5 und der Arbeitsfokus 6 auf einer geraden Linie. Dies bedeutet, daß die vom Zwischenfokus 4 in die verschiedenen Richtungen ausgehenden einzelnen Elektronenstrahlen des Bündels nach Passieren der Linse 5 alle wieder in den Arbeitsfokus 6 hinein laufen. Das gleiche gilt auch, wenn ein Ablenksystem 9 genau im Zwischenfokus 4 angeordnet wird und dort den Elektronenstrahl ablenkt, also seine Richtung ändert: auch wenn die Richtung der aus dem Punkt 4 austretenden Strahlen mit der Zeit verändert wird (durch die Wirkung des Ablenksystemes 9) laufen diese Strahlen nach Passieren der Linse 5 wieder durch den Punkt 6 (den Arbeitsfokus) , es sei denn, der Strahl wird soweit abgelenkt, daß er von der Blende 10 abgeschattet wird, wie in Fig. 2b und 2c dargestellt.

**Ansprüche**

1. Verwendung eines im Zwischenfokusbereich (8) zwischen zwei Linsen (3, 5) angeordneten Ablenksystemes (9) und einer zwischen dem Ablenksystem (9) und der zweiten Linse (5) angeordneten Strahlblende (10) zum Erzeugen von Elektronenstrahlimpulsen durch Ablenken des Elektronenstrahles (2) auf die Strahlblende (10) oder auf eine Werkstückanordnung (7)

2. Verwendung nach Anspruch 1, gekennzeichnet durch die Anordnung des Ablenksystemes (9) im Zwischenfokus (4).

3. Elektronenstrahlimpulserzeuger bestehend aus einer ersten teilchenoptischen Linse (3), die die Elektronenstrahlen (2) in einem Zwischenfokus (4) , in dem der effektive Strahlenquerschnitt ein Minimum hat, fokusiert, einer zweiten teilchenoptischen Linse, die den vom Zwischenfokus (4) wieder divergierenden Elektronenstrahl (2) in eine Bearbeitungszone einer Werkstückanordnung (7) fokusiert und einem zwischen den Linsen (3, 5) angeordneten Ablenksystem (9) sowie eine nach dem Ablenksystem (9) angeordnete Strahlblende (10), wobei der Elektronenstrahl (2) mittels des Ablenksystemes (9) auf die Strahlblende (10) oder auf eine Werkstückanordnung (7) gerichtet werden kann.

Fig.1a    Fig.1b    Fig.1c    Fig.1d

Fig.2a          Fig.2b          Fig.2c          Fig.2d

Europäisches
Patentamt

EUROPÄISCHER
RECHERCHENBERICHT

Nummer der Anmeldung

EP 90 11 7843

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 801 792 (LIN) <br> * Spalte 1, Zeilen 46-50; Spalte 4, Zeile 66 - Spalte 5, Zeile 16, Zeilen 21-24,56-65; Figur 4 * <br> − − − | 1,2 | H 01 J <br> 37/04 <br> H 01 J 37/147 |
| Y <br> Y,D | DE-C-2 815 478 (MESSER GRIESHEIM) <br> * Spalte 1, Zeilen 3-16; Spalte 4, Zeilen 16-18; Figur 1 * <br> − − − | 3 <br> 3 | |
| A | GB-A-2 099 626 (HEWLETT-PACKARD) <br> * Seite 2, Zeile 103 - Seite 3, Zeile 6; Figur 2 * <br> − − − − − | 1 | |

RECHERCHIERTE
SACHGEBIETE (Int. Cl.5)

H 01 J

Der vorliegende Recherchenbericht wurde für alle Patentansprüche erstellt

| Recherchenort | Abschlußdatum der Recherche | Prüfer |
|---|---|---|
| Den Haag | 08 Januar 91 | GREISER N. |